# EUROPEAN PATENT APPLICATION

(11) **EP 4 818 048 A1**
(43) Date of publication of application: **07.10.2026**
(21) Application number: 26170668.3
(22) Date of filing: 02.04.2026
(51) Int. Cl.: B64D 33/00, H01B 9/02, H05K 9/00, H02K 11/01

(54) **AIRCRAFT POWERPLANT WITH SHIELDED CONTROL SYSTEM COMPONENT(S)**

(30) Priority: 04.04.2025 US 202519170776
(71) Applicant: RTX Corporation, Farmington, CT 06032 (US)
(72) Inventor: CLARK, Thomas E., Wells (US); AKIN, John, Charlotte (US); CHOE, Jung Muk, Glastonbury (US)
(74) Representative: Dehns

(57) **Abstract**

An assembly is provided for an aircraft powerplant (20). This assembly includes an aircraft engine, a control system (98) and a conduit (112). The control system includes an electronic engine controller (104), a first electric device and a first electric cable electrically coupling the first electric device to the electronic engine controller. The electronic engine controller is configured to control operation of the aircraft engine using the first electric device. The conduit extends longitudinally from a first end (114) of the conduit to a second end (116) of the conduit. The first electric cable extends longitudinally in a bore (126) of the conduit between the electronic engine controller and the first electric device. The conduit is configured to shield the first electric cable from electromagnetic interference generated outside of the conduit.

## Description

### BACKGROUND OF THE DISCLOSURE

### 1. Technical Field

This disclosure relates generally to an aircraft and, more particularly, to a control system for the aircraft.

### 2. Background Information

An aircraft propulsion system may include a control system with various components. Various control systems are known in the art. While these known control systems have various benefits, there is still room in the art for improvement.

### SUMMARY OF THE DISCLOSURE

According to an aspect of the present disclosure, an assembly is provided for an aircraft powerplant. This assembly includes an aircraft engine, a control system and a conduit. The control system includes an electronic engine controller, a first electric device and a first electric cable electrically coupling the first electric device to the electronic engine controller. The electronic engine controller is configured to control operation of the aircraft engine using the first electric device. The conduit extends longitudinally from a first end of the conduit to a second end of the conduit. The first electric cable extends longitudinally in a bore of the conduit between the electronic engine controller and the first electric device. The conduit is configured to shield the first electric cable from electromagnetic interference generated outside of the conduit.

According to another aspect of the present disclosure, another assembly is provided for an aircraft powerplant. This assembly includes an aircraft engine, a control system and a conduit. The control system includes an electronic engine controller, a first electric device and a first electric cable electrically coupling the first electric device to the electronic engine controller. The electronic engine controller is configured to control operation of the aircraft engine using the first electric device. The conduit extends longitudinally from a first end of the conduit to a second end of the conduit. The first electric cable extends longitudinally in a bore of the conduit between the electronic engine controller and the first electric device. A sidewall of the conduit includes a first layer and a second layer adjacent the first layer. The first layer is configured from or otherwise includes metal. The second layer is configured from or otherwise includes dielectric material.

According to still another aspect of the present disclosure, another assembly is provided for an aircraft powerplant. This assembly includes an aircraft engine, a control system and a shield structure. The control system includes an electronic engine controller, a first electric device and a first electric cable electrically coupling the first electric device to the electronic engine controller. The electronic engine controller is configured to control operation of the aircraft engine using the first electric device. The shield structure is configured to shield the electronic engine controller from electromagnetic interference generated by a source remote from the electronic engine controller. The shield structure includes an open receptacle. The electronic engine controller is seated in the open receptacle. A wall of the shield structure includes a first layer and a second layer adjacent the first layer. The first layer is configured from or otherwise includes metal. The second layer is configured from or otherwise includes dielectric material.

The first electric device may be configured as or otherwise include a sensor. The sensor may be configured to communicate sensor data to the electronic engine controller through the first electric cable.

The first electric device may be configured as or otherwise include an actuatable device. The electronic engine controller may be configured to communicate a command to the actuatable device through the first electric cable.

The first electric device may be configured as or otherwise include a second electronic controller. The electronic engine controller and the second electronic controller may be configured to communicate through the first electric cable.

The assembly may also include an electric machine system operable to generate the electromagnetic interference.

The electric machine system may include: an electric machine operatively coupled to the aircraft engine; and an electric machine controller configured to control operation of the electric machine.

The first end of the conduit may be disposed at the electronic engine controller. The second end of the conduit may be disposed at the first electric device.

A sidewall of the conduit may include non-ferrous metal and/or dielectric material.

A sidewall of the conduit may include a first layer and a second layer extending along the first layer. The first layer may be configured as or otherwise include non-ferrous metal. The second layer may be configured as or otherwise include dielectric material.

The second layer may extend along and may circumscribe the first electric cable. The first layer may extend along and may circumscribe the second layer.

The first layer may extend along and may circumscribe the first electric cable. The second layer may extend along and may circumscribe the first layer.

The second layer may engage and/or may be attached to the first layer.

The second layer may be spaced from the first layer by an air gap.

The sidewall of the conduit may also include a third layer extending along the first layer and the second layer. The third layer may be configured from or otherwise include the non-ferrous metal.

The sidewall of the conduit may also include a third layer extending along the first layer and the second layer. The third layer may be configured from or otherwise include a second metal that is different than the non-ferrous metal of the first layer.

The aircraft engine may be configured as or otherwise include a turbine engine.

The control system may also include a second electric device and a second electric cable electrically coupling the second electric device to the electronic engine controller. The second electric cable may extend longitudinally in the bore of the conduit between the electronic engine controller and the second electric device.

The assembly may also include a housing structure for the aircraft engine. The housing structure may include an inner case and an outer case with a bypass flowpath disposed radially between the inner case and the outer case. A first portion of the conduit may extend along the inner case. A second portion of the conduit may extend along the outer case.

The housing structure may also include a bifurcation structure extending radially across the bypass flowpath. A third portion of the conduit may extend through the bifurcation structure.

The assembly may also include a shield structure for the electronic engine controller. The shield structure may be configured to shield the electronic engine controller from the electromagnetic interference generated outside of the electronic engine controller.

The shield structure may include an open receptacle. The open receptacle may project into the shield structure. The electronic engine controller may be seated in the open receptacle.

The present disclosure may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a partial schematic illustration of an aircraft propulsion system.
FIG. 2 is a schematic illustration of a portion of the aircraft propulsion system with a control system and an electric machine system.
FIG. 3 is a schematic illustration of a portion of the aircraft propulsion system with electric cables extending through a cable conduit.
FIG. 4 is a partial side illustration of the control system with a propulsion system housing.
FIG. 5 is a partial end view illustration of the control system with the propulsion system housing.
FIG. 6 is a schematic illustration of a conduit wall with a single layer construction covering the electric cables.
FIGS. 7A-C are schematic illustrations of the conduit wall with various multi-layer constructions covering the electric cables.
FIG. 8 is a schematic illustration of a portion of the aircraft propulsion system with a shield structure covering an electronic engine controller.
FIG. 9 is a schematic illustration of a structure wall with a single layer construction covering the electronic engine controller.
FIGS. 10A-C are schematic illustrations of the structure wall with various multi-layer constructions covering the electronic engine controller.
FIG. 11 is a schematic illustration of a portion of the aircraft propulsion system at an electric machine system.

### DETAILED DESCRIPTION

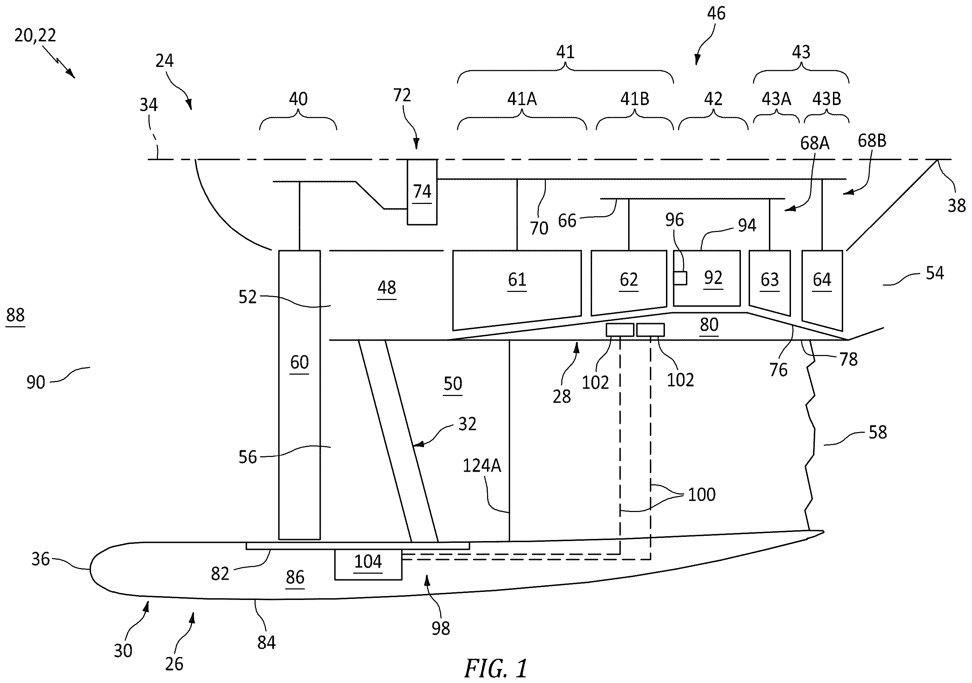

FIG. 1 illustrates a powerplant 20 for an aircraft. The aircraft may be an airplane, a drone (e.g., an unmanned aerial vehicle (UAV)) or any other manned or unmanned aerial vehicle or system. For ease of description, the aircraft powerplant 20 is described below as a propulsion system 22 for the aircraft and, more particularly, as a turbofan propulsion system. The aircraft powerplant 20 of the present disclosure, however, is not limited to such an exemplary propulsion system. The aircraft propulsion system 22, for example, may alternatively be configured as a turbojet propulsion system, a turboprop propulsion system, a turboshaft propulsion system, a propfan propulsion system, a pusher fan propulsion system, or any other type of ducted and/or open rotor propulsion system. Moreover, the aircraft powerplant 20 is not limited to propulsion system applications. The aircraft powerplant 20, for example, may also (or alternatively) be configured as an electrical power system for the aircraft; e.g., an auxiliary power unit (APU).

The aircraft propulsion system 22 includes a gas turbine engine 24 (e.g., a turbofan engine) housed within a stationary housing structure 26, which housing structure 26 of FIG. 1 includes an inner housing structure 28, an outer housing structure 30 and a guide vane structure 32 (e.g., a fan exit guide vane (FEGV) structure) extending radially between and connected to the inner housing structure 28 and the outer housing structure 30. The aircraft propulsion system 22 extends axially along a propulsion system axis 34 between an axial upstream, forward end 36 of the aircraft propulsion system 22 and an axial downstream, aft end 38 of the aircraft propulsion system 22. Briefly, the propulsion system axis 34 may be a centerline axis of the aircraft propulsion system 22, the turbine engine 24 and/or one or more of its members. The propulsion system axis 34 may also or alternatively be a rotational axis for one or more members of the turbine engine 24.

The aircraft propulsion system 22 and its turbine engine 24 of FIG. 1 include a propulsor section 40 (e.g., a fan section), a compressor section 41, a combustor section 42 and a turbine section 43. The compressor section 41 of FIG. 1 includes a low pressure compressor (LPC) section 41A and a high pressure compressor (HPC) section 41B. The turbine section 43 of FIG. 1 includes a high pressure turbine (HPT) section 43A and a low pressure turbine (LPT) section 43B. At least (or only) the LPC section 41A, the HPC section 41B, the combustor section 42, the HPT section 43A and the LPT section 43B collectively form a core 46 (e.g., a gas generator) of the turbine engine 24. The aircraft propulsion system 22 and its turbine engine 24 of FIG. 1 also include a core flowpath 48 (e.g., an annular core flowpath) and a bypass flowpath 50 (e.g., an annular bypass flowpath). The core flowpath 48 extends sequentially through the LPC section 41A, the HPC section 41B, the combustor section 42, the HPT section 43A and the LPT section 43B from an airflow inlet 52 into the core flowpath 48 to a combustion products exhaust 54 out from the core flowpath 48. The bypass flowpath 50 extends through a bypass duct from an airflow inlet 56 into the bypass flowpath 50 to an airflow exhaust 58 from the bypass flowpath 50, where the bypass duct may be formed by the inner housing structure 28 and the outer housing structure 30. The bypass flowpath 50 and its bypass duct are configured to bypass (e.g., are disposed radially outboard of and extend along) the engine core 46 and the inner housing structure 28.

The propulsor section 40, the LPC section 41A, the HPC section 41B, the combustor section 42, the HPT section 43A and the LPT section 43B may be arranged sequentially along the propulsion system axis 34 within the housing structure 26. The propulsor section 40 includes a bladed propulsor rotor 60; e.g., a fan rotor. The LPC section 41A includes a bladed low pressure compressor (LPC) rotor 61. The HPC section 41B includes a bladed high pressure compressor (HPC) rotor 62. The HPT section 43A includes a bladed high pressure turbine (HPT) rotor 63. The LPT section 43B includes a bladed low pressure turbine (LPT) rotor 64. Each of these engine rotors 60-64 includes a rotor base (e.g., a disk or a hub) and a plurality of rotor blades (e.g., airfoils, vanes, etc.). The rotor blades may be arranged into one or more stages axially along the respective engine rotor 60-64. The rotor blades in each stage are arranged and may be equispaced circumferentially around the respective rotor base in an annular array. Each of the rotor blades is connected to the respective rotor base. The rotor blades, for example, may be formed integral with or mechanically fastened, welded, brazed and/or otherwise attached to the respective rotor base. Each of the rotor blades projects spanwise (e.g., radially) out from the respective rotor base to a distal tip of the respective rotor blade.

The HPC rotor 62 is coupled to and rotatable with the HPT rotor 63. The HPC rotor 62 of FIG. 1, for example, is connected to the HPT rotor 63 through a high speed shaft 66. At least (or only) the HPC rotor 62, the HPT rotor 63 and the high speed shaft 66 collectively form a high speed rotating structure 68A; e.g., a high speed spool of the turbine engine 24 and its engine core 46. This high speed rotating structure 68A of FIG. 1 and its members 62, 63 and 66 are rotatable about the propulsion system axis 34. However, it is contemplated the high speed rotating structure 68A may alternatively be rotatable about another axis radially and/or angularly offset from the rotational axis of the propulsor rotor 60 and/or the centerline axis of the turbine engine 24.

The LPC rotor 61 is coupled to and rotatable with the LPT rotor 64. The LPC rotor 61 of FIG. 1, for example, is connected to the LPT rotor 64 through a low speed shaft 70. At least (or only) the LPC rotor 61, the LPT rotor 64 and the low speed shaft 70 collectively form a low speed rotating structure 68B; e.g., a low speed spool of the turbine engine 24 and its engine core 46. This low speed rotating structure 68B of FIG. 1 and its members 61, 64 and 70 are rotatable about the propulsion system axis 34. However, it is contemplated the low speed rotating structure 68B may alternatively be rotatable about another axis radially and/or angularly offset from the rotational axis of the propulsor rotor 60 and/or the centerline axis of the turbine engine 24.

The low speed rotating structure 68B is coupled to the propulsor rotor 60 through a rotating structure-to-propulsor (RSP) drivetrain 72. The RSP drivetrain 72 may be configured as a geared drivetrain, where a geartrain 74 (e.g., a transmission, a speed change device, an epicyclic geartrain, etc.) is disposed between and operatively couples the propulsor rotor 60 to the low speed rotating structure 68B and its LPT rotor 64. With this arrangement, the propulsor rotor 60 may rotate at a different (e.g., slower) rotational speed than the low speed rotating structure 68B and its LPT rotor 64. Here, the propulsor rotor 60 and the low speed rotating structure 68B may rotate in a common (the same) direction about the propulsion system axis 34 or in opposite directions about the propulsion system axis 34 depending, for example, upon the specific configuration of the geartrain 74. Alternatively, the RSP drivetrain 72 may be configured as a direct-drive drivetrain, where the geartrain 74 is omitted. With such an arrangement, the propulsor rotor 60 rotates at a common (the same) rotational speed as the low speed rotating structure 68B and its LPT rotor 64.

The inner housing structure 28 of FIG. 1 includes an inner case 76 (e.g., a core case) for the turbine engine 24, an inner nacelle structure 78 (sometimes referred to as an inner fixed structure (IFS)) and an internal inner housing compartment 80 (e.g., an engine core compartment). The inner case 76 is disposed radially outboard of, extends axially along and may circumscribe one or more or all of the engine sections 41A-43B and the engine rotors 61-64. The inner case 76 may thereby house and provide a support structure for the respective engine sections 41A-43B and the engine rotors 61-64. The inner nacelle structure 78 is configured to provide an aerodynamic cover over the engine core 46 and its inner case 76. The inner housing compartment 80 of FIG. 1 is formed by and is disposed radially between the inner case 76 and an inner barrel of the inner nacelle structure 78. The inner housing structure 28 and its inner nacelle structure 78 may also form a radial inner peripheral boundary of the bypass flowpath 50.

The outer housing structure 30 of FIG. 1 includes an outer case 82 (e.g., a fan case) for the turbine engine 24, an outer nacelle structure 84 and an internal outer housing compartment 86. The outer case 82 is disposed radially outboard of, extends axially along and may circumscribe the propulsor section 40 and its propulsor rotor 60. The outer case 82 may thereby house and may be configured as a containment structure for the propulsor section 40 and its propulsor rotor 60. The outer nacelle structure 84 is configured to provide an aerodynamic cover over the outer case 82. The outer housing compartment 86 of FIG. 1 is at least partially formed by and disposed radially between the outer case 82 and an outer portion (e.g., fan cowls) of the outer nacelle structure 84. The outer housing structure 30 and its outer nacelle structure 84 may also form a radial outer peripheral boundary of the bypass flowpath 50.

During operation of the aircraft propulsion system 22 of FIG. 1, ambient air from an environment 88 external to the aircraft and its aircraft propulsion system 22 enters the aircraft propulsion system 22 and its turbine engine 24 through an airflow inlet 90. This air is propelled by the rotating propulsor rotor 60 in a downstream, aft direction towards the propulsion system aft end 38.

An outer stream of the air propelled by the rotating propulsor rotor 60 is directed into the bypass flowpath 50 through its bypass inlet 56, which air entering the bypass flowpath 50 may be referred to as "bypass air". The guide vane structure 32 conditions (e.g., straightens out, de-swirls, etc.) the flow of the bypass air within the bypass duct. This conditioned bypass air is subsequently directed out of the aircraft propulsion system 22 through the bypass exhaust 58 to provide forward thrust. This propulsion of the bypass air may account for a majority of the forward thrust generated by the aircraft propulsion system 22 and its turbine engine 24 of FIG. 1.

An inner stream of the air propelled by the rotating propulsor rotor 60 is directed into the core flowpath 48 through its core inlet 52, which air entering the core flowpath 48 may be referred to as "core air". This core air is compressed by the LPC rotor 61 and the HPC rotor 62 and is directed into a combustion chamber 92 (e.g., annular combustion chamber) of a combustor 94 (e.g., annular combustor) in the combustor section 42. Fuel is injected into the combustion chamber 92 by one or more fuel injectors 96 and mixed with the compressed core air to provide a fuel-air mixture. This fuel-air mixture is ignited and combustion products thereof flow through and sequentially drive rotation of the HPT rotor 63 and the LPT rotor 64. The rotation of the HPT rotor 63 and the LPT rotor 64 respectively drive rotation of the HPC rotor 62 and the LPC rotor 61 and, thus, compression of the air received from the core inlet 52. The rotation of the LPT rotor 64 also drives rotation of the propulsor rotor 60 through the RSP drivetrain 72.

While the turbine engine 24 is described above with a particular two rotating structure arrangement (e.g., a two-spool architecture), the present disclosure is not limited thereto. For example, the LPC rotor 61 may be omitted to configure the LPT rotor 64 as a power turbine (PT) rotor for the propulsor rotor 60. The turbine engine 24 may also or alternatively include another rotating structure with a bladed compressor rotor in the compressor section 41 and a bladed turbine rotor in the turbine section 43; e.g., an intermediate speed spool for the engine core 46.

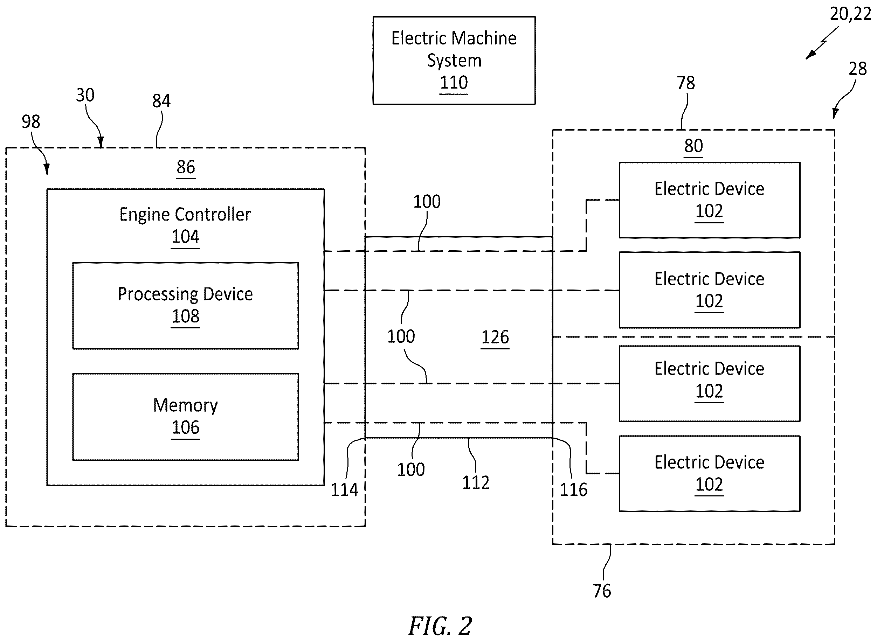

Referring to FIG. 2, the aircraft propulsion system 22 includes a control system 98. This control system 98 is configured to control operation of the aircraft propulsion system 22, the turbine engine 24 and/or one or more other propulsion system sub-systems. The control system 98 is also configured to monitor the operation of the aircraft propulsion system 22, the turbine engine 24 and/or one or more other propulsion system sub-systems. The control system 98 of FIG. 2 includes one or more electric cables 100, one or more electric devices 102 and an electronic engine controller 104 (EEC). Note, while the control system 98 of FIG. 2 is shown with four (4) of the electric devices 102, it is contemplated this control system 98 may alternatively include more than four of the electric devices 102 or less than four of the electric devices 102.

The electric cables 100 are configured to respectively electrically couple the electric devices 102 to the electronic engine controller 104. This electric coupling may facilitate (e.g., low voltage) signal communication between one or more of the electric devices 102 and the electronic engine controller 104. The electric coupling may also or alternatively facilitate (e.g., low voltage) electric power transfer between one or more of the electric devices 102 and the electronic engine controller 104. For ease of illustration, each electric device 102 is shown in FIG. 2 as being associated with a single one of the electric cables 100. Each electric cable 100 of FIG. 2, for example, extends longitudinally from the electronic engine controller 104 to a respective one of the electric devices 102. At the electronic engine controller 104, a respective one of the electric cables 100 may be electrically coupled to internal electrical circuitry of the electronic engine controller 104 through a respective cable-controller terminal. At each electric device 102, a respective one of the electric cables 100 may be electrically coupled to internal electrical circuitry of the electric device 102 through a cable-device terminal. Of course, it is contemplated one or more or all of the single electric cables 100 of FIG. 2 may each be replaced by a set of two or more electrical cables electrically coupling a respective one of the electric devices 102 to the electronic engine controller 104.

The electric devices 102 may include one or more sensors, one or more sub-system electronic controllers and/or one or more actuatable devices. Examples of the sensors include, but are not limited to, any one or more of the following:
- one or more temperature sensors such as ambient temperature sensor(s), core air temperature sensor(s), combustion products temperature sensor(s), bypass air temperature sensor(s), cooling air temperature sensor(s), lubricant temperature sensor(s), fuel temperature sensor(s), coolant temperature sensor(s), and/or the like;
- one or more pressure sensors such as ambient pressure sensor(s), core air pressure sensor(s), combustion products pressure sensor(s), bypass air pressure sensor(s), cooling air pressure sensor(s), lubricant pressure sensor(s), fuel pressure sensor(s), coolant pressure sensor(s), and/or the like;
- one or more speed sensors such as propulsor rotor speed sensor(s), low pressure rotating structure speed sensor(s), high pressure rotating structure speed sensor(s), and/or the like;
- one or more position sensors such as vane position sensor(s), valve position sensor(s), and/or the like; and/or
- one or more electrical sensors such as current sensor(s), voltage sensor(s), and/or the like.
Examples of the sub-system electronic controllers include, but are not limited to, one or more electric machine controllers such as motor controller(s), generator controller(s), motor-generator controller(s), and/or the like. The actuatable devices may be any device with at least one electric element controlled by or otherwise in signal communication with the electronic engine controller 104 through the respective electric cable 100. Examples of the electric element include, but are not limited to, an electric switch (e.g., a contactor), a current regulator, a voltage regulator, an electric actuator motor, and/or the like. Examples of the actuatable devices include, but are not limited to, any one or more of the following:
- one or more electric actuators such as electric linear actuator(s), electric rotary actuator(s), and/or the like;
- one or more electric pumps such as electric fuel pump(s), electric lubricant pump(s), electric coolant pump(s), electric air compressor(s), and/or the like;
- one or more electric valves; and/or
- one or more electric fluid separators.

The electric devices 102 are arranged to facilitate operation of the aircraft propulsion system 22 and its turbine engine 24. The electric devices 102, for example, may be configured as part of one or more sub-systems for the aircraft propulsion system 22 and its turbine engine 24. Examples of these sub-systems include, but are not limited to, any one or more of the following:
- a fuel system for delivering the fuel to the fuel injectors (see FIG. 1);
- a lubrication system for delivering lubricant (e.g., engine oil) to and/or circulating the lubricant through one or more lubricated components of the aircraft propulsion system 22 such as bearing(s), gear system(s), seal system(s), and/or the like;
- a cooling system for delivering coolant (e.g., fuel, lubricant or another liquid coolant, air, etc.) to and/or circulating the lubricant through one or more fluid cooled components of the aircraft propulsion system 22 such as heat exchanger(s), engine component(s), and/or the like; and/or
- an actuation system for moving one or more pivotable, translatable, rotatable and/or otherwise adjustable component of the aircraft propulsion system 22 such as variable guide vane(s), variable area nozzle(s), valve body(ies), rotor body(ies), and/or the like.
The present disclosure, however, is not limited to the foregoing exemplary electric devices or sub-systems which may include one, some or all of those electric devices.

The electronic engine controller 104 is an onboard electronic controller (e.g., a full-authority digital engine controller (FADEC)) configured to control operation of the aircraft propulsion system 22 and its turbine engine 24 using at least the electric devices 102. For example, during the propulsion system operation, the electronic engine controller 104 may receive sensor data (e.g., sensor signal(s)) from one or more of the electric devices 102; e.g., the sensor(s). The electronic engine controller 104 may process this sensor data to then provide command data (e.g., control signal(s)) to one or more of the other electric devices 102; e.g., the sub-system electronic controller(s) and/or the actuatable device(s). The electronic engine controller 104 may also or alternatively provide command data to one or more of the other electric devices 102 (e.g., the sub-system electronic controller(s) and/or the actuatable device(s)) based on command data (e.g., control signal(s)) received from a user interface; e.g., an aircraft pilot control station.

The electronic engine controller 104 may be implemented with a combination of hardware and software. The hardware may include memory 106 and at least one processing device 108, which processing device 108 may include one or more single-core and/or multi-core processors. The memory 106 is configured to store software (e.g., program instructions) for execution by the processing device 108, which software execution may control and/or facilitate performance of at least the various operations described herein. The hardware may also or alternatively include analog and/or digital circuitry other than that described above.

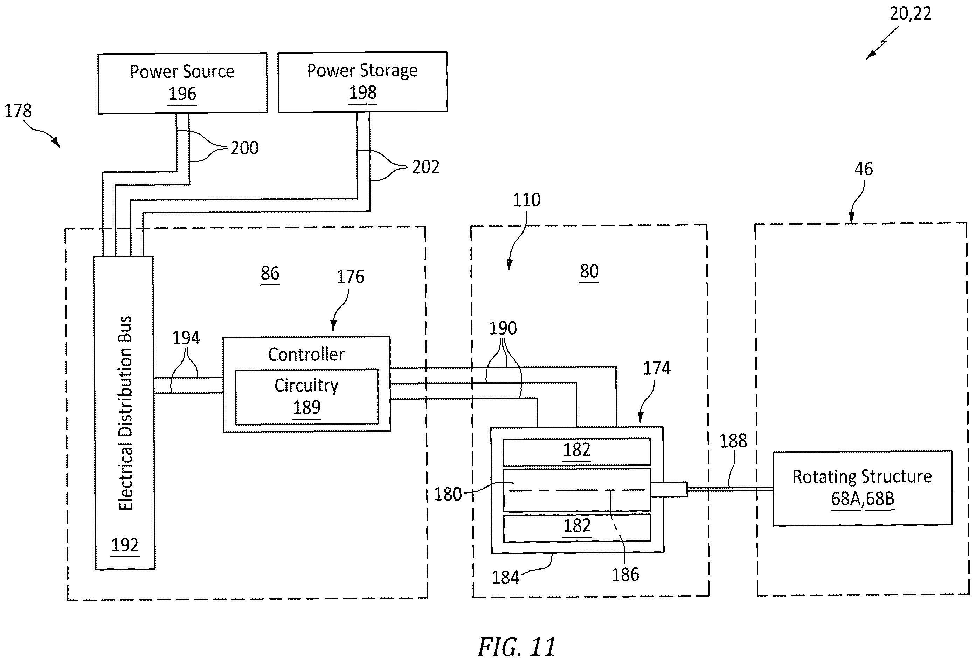

Various components and/or sub-systems of the aircraft propulsion system 22 may generate and propagate electromagnetic interference (EMI) during operation thereof. The aircraft propulsion system 22 of FIG. 2, for example, may include an electric machine system 110 operatively coupled to the turbine engine 24 (see FIGS. 1 and 11), and example of which is described below in further detail. Various members of this electric machine system 110 may be operated with relatively high power; e.g., in a kilowatts (kW) power class and/or a megawatts (MW) power class. Examples of these members include, but are not limited to, electric machine(s), electric machine controller(s), electric cables transferring electrical power to and/or from the electric machine(s) and/or the electric machine controller(s), and the like. Briefly, the electric machine(s) may be configured as electric generator(s), electric motor(s) and/or electric motor-generator(s). The electric machine controller(s) may be configured as generator controller(s), motor controller(s) and/or motor-generator controller(s). During operation of the electric machine system 110, one or more of the electric machine members may generate electromagnetic interference and the electromagnetic interference may be propagated (e.g., radiated) therefrom. Such electromagnetic interference may disrupt, alter and/or otherwise interact with electrical transmissions (e.g., signal communications or the like) through the electric cables 100 between the electric devices 102 and the electronic engine controller 104. To reduce or eliminate electromagnetic interference interaction with the electrical transmissions through the electric cables 100 between the electric devices 102 and the electronic engine controller 104, the electric cables 100 of FIG. 2 are arranged with a cable conduit 112 (e.g., an EMI shield) configured to block, deflect and/or otherwise shield the electromagnetic interference from the electric cables 100. This cable conduit 112 may also be configured to block, deflect and/or otherwise shield the electric cables 100 from heat energy; e.g., heat radiated from the engine core 46 (see FIG. 1) and/or the electric machine system 110. For ease of description, the cable conduit 112 is described below as collectively servicing the electric cables 100. However, it is contemplated multiple cable conduits may alternatively be provided, where each cable conduit is dedicated to a specific one of the electric cables 100 or a specific grouping of the electric cables 100.

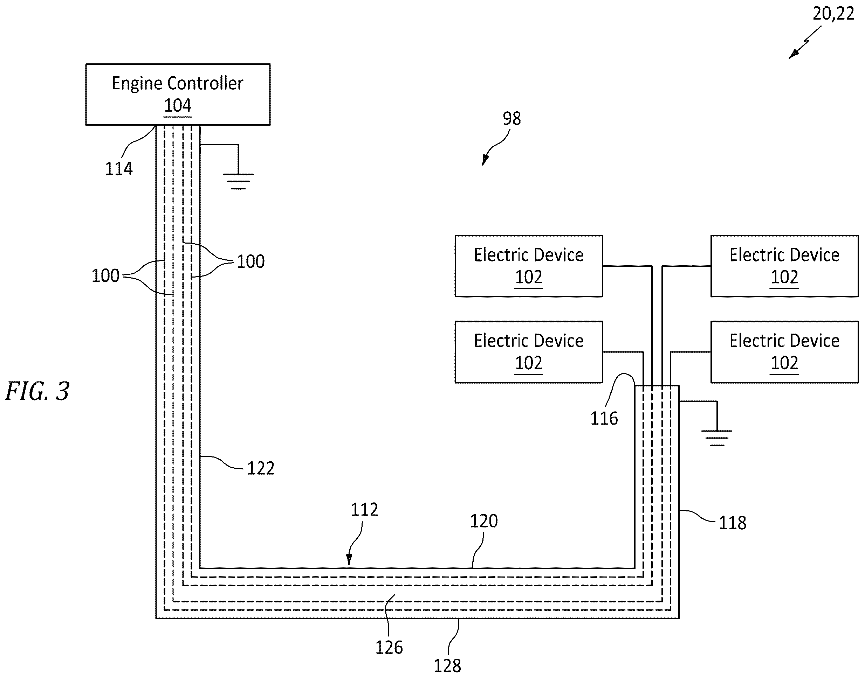

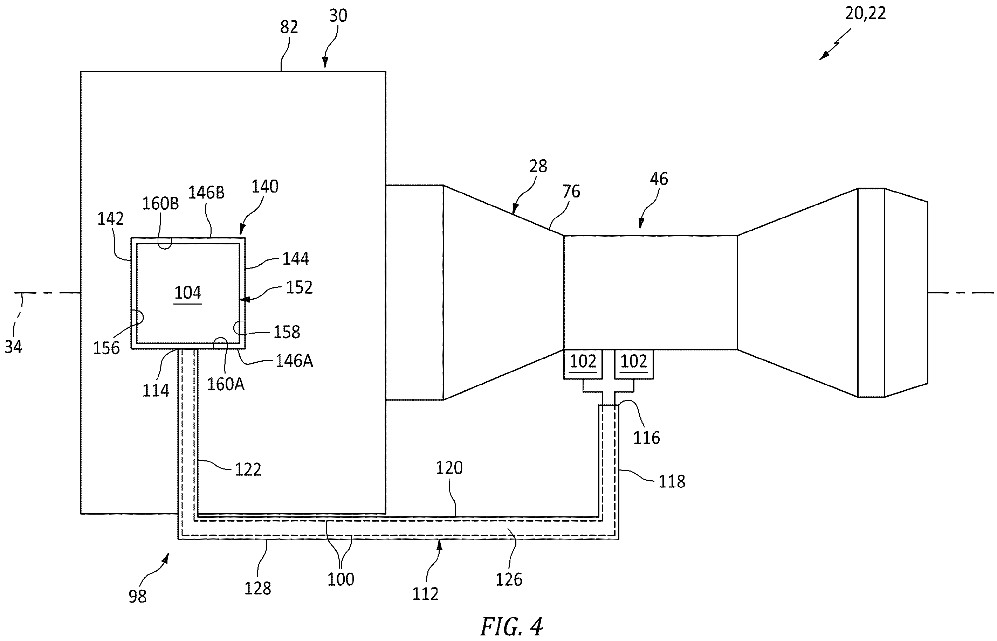

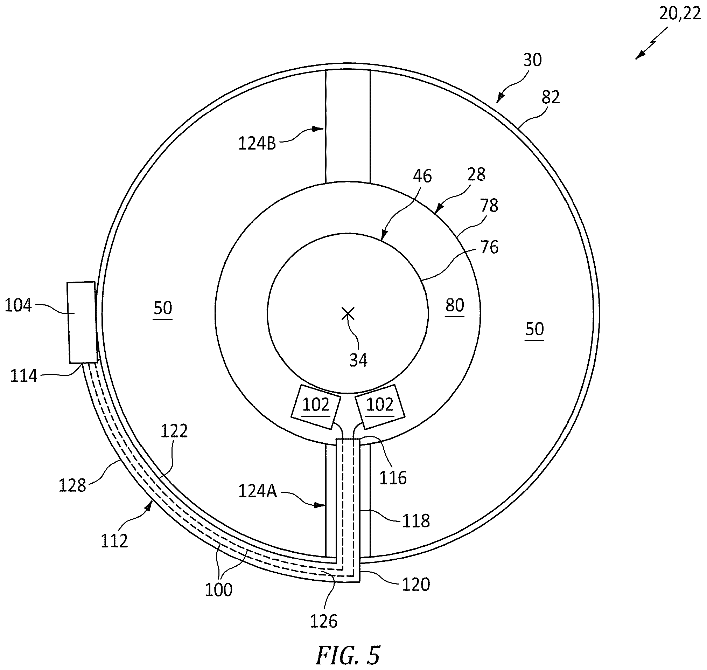

Referring to FIG. 3, the cable conduit 112 extends longitudinally along a centerline of the cable conduit 112 from a first end 114 of the cable conduit 112 to a second end 116 of the cable conduit 112. Referring to FIGS. 4 and 5, the conduit first end 114 may be an outer and/or forward end of the cable conduit 112. This conduit first end 114 may be disposed next to and/or otherwise proximate the electronic engine controller 104. Here, the electronic engine controller 104 is disposed within the outer housing compartment 86 (see also FIG. 1) and may be mounted (e.g., directly or indirectly) to the outer case 82. The conduit second end 116 may be an inner and/or aft end of the cable conduit 112. This conduit second end 116 may be disposed next to and/or otherwise proximate one or more of the electric devices 102, only some of which are shown of clarity of illustration in FIGS. 1, 4 and 5. Here, each electric device 102 is disposed within the inner housing compartment 80 (see also FIG. 1) and may be mounted (e.g., directly or indirectly) to the inner case 76. Of course, one or more of the electric devices 102 may alternatively be disposed inside of the inner case 76 and/or otherwise located with the aircraft propulsion system 22.

The cable conduit 112 of FIG. 4 and 5 and its conduit centerline may follow a tortuous (e.g., bending and/or otherwise non-straight) trajectory from the conduit first end 114 to the conduit second end 116. The cable conduit 112 of FIGS. 4 and 5, for example, includes one or more conduit segments such as a radial conduit segment 118, an axial conduit segment 120 and a circumferential conduit segment 122. The radial conduit segment 118 of FIG. 4 projects radially outward (e.g., away from the propulsion system axis 34) from the conduit second end 116 and meets the axial conduit segment 120 at a corner; e.g., a relatively tight radiused bend in the cable conduit 112 at an intersection between the radial conduit segment 118 and the axial conduit segment 120. Referring to FIG. 5, this radial conduit segment 118 may be circumferentially aligned with and projects radially through an interior of a vane structure such as a lower bifurcation structure 124A (or alternatively an upper bifurcation structure 124B) that extends radially across the bypass flowpath 50. Referring to FIG. 4, the axial conduit segment 120 extends axially along the propulsion system axis 34 between the radial conduit segment 118 and the circumferential conduit segment 122. The axial conduit segment 120 meets the circumferential conduit segment 122 at a corner; e.g., a relatively tight radiused bend in the cable conduit 112 at an intersection between the axial conduit segment 120 and the circumferential conduit segment 122. An aft portion of the axial conduit segment 120 is radially spaced outward from and axially overlaps (e.g., extends axially along) the inner housing structure 28 and its inner case 76. A forward portion of the axial conduit segment 120 is radially outboard of and axially overlaps the outer case 82. Referring to FIGS. 4 and 5, the circumferential conduit segment 122 projects circumferentially about the propulsion system axis 34 along the outer case 82 from the conduit first end 114 and meets the axial conduit segment 120 at a corner; e.g., a relatively tight radiused bend in the cable conduit 112 at an intersection between the circumferential conduit segment 122 and the axial conduit segment 120. The present disclosure, however, is not limited to such an exemplary cable conduit arrangement. For example, one or more of the foregoing conduit segments 118, 120 and/or 122 may be omitted, replaced by one or more other conduit segments and/or one or more other conduit segments may be included in addition to the foregoing conduit segments 118, 120 and 122.

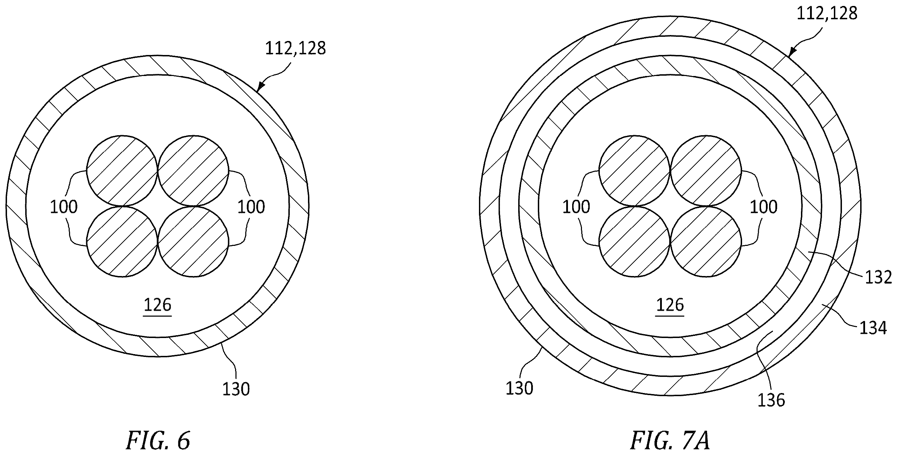

Referring to FIG. 3, the cable conduit 112 may be a tubular structure with an internal bore 126 (see also FIGS. 6-7C); e.g., an internal passage. This conduit bore 126 of FIG. 3 extends longitudinally along the conduit centerline within the cable conduit 112 from an opening at the conduit first end 114 to an opening at the conduit second end 116. With this arrangement, each of the electric cables 100 may extend longitudinally within the cable conduit 112 and through its conduit bore 126 between the electronic engine controller 104 and the respective electric device 102. Segments of the electric cables 100 within the cable conduit 112 may also be supported by a tubular sidewall 128 of the cable conduit 112 as well as sheathed by the conduit sidewall 128.

In some embodiments, referring to FIG. 6, at least a portion or an entirety of the cable conduit 112 and its conduit sidewall 128 may be configured with a single layer construction. The conduit sidewall 128 of FIG. 6, for example, is formed by a layer of shield material. This shield material may be selected based on various factors including an electromagnetic interference (EMI) noise frequency range to be shielded. Here, this layer of shield material extends between and forms at least a portion or an entirety of the conduit bore 126 and at least a portion or an entirety of an exterior 130 of the cable conduit 112. Examples of this shield material include, but are not limited to, ferrous metal, non-ferrous metal, dielectric material, and high permeability material. Examples of the ferrous metal include, but are not limited to, steel, stainless steel, alloy steel and/or carbon steel. Examples of the non-ferrous metal include, but are not limited to, aluminum (Al), copper (Cu), titanium (Ti) and/or an alloy thereof. A non-limiting example of the dielectric material is silicon carbide (SiC). A non-limiting example of the high permeability material is mu (µ) metal, which mu metal may be manufactured using mixed powder metal with nickel, nickel alloy, steel, etc.

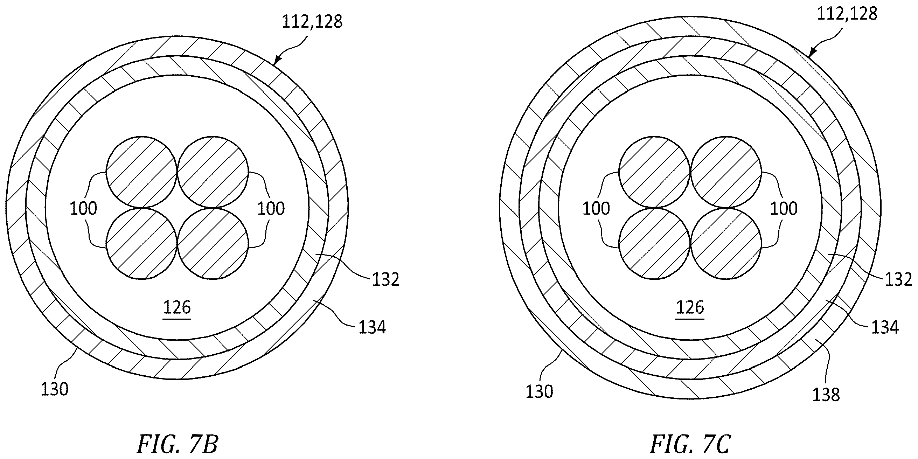

In some embodiments, referring to FIGS. 7A and 7B, at least a portion or an entirety of the cable conduit 112 and its conduit sidewall 128 may be configured with a multi-layer construction. The conduit sidewall 128 of FIGS. 7A and 7B, for example, includes a first layer 132 and a second layer 134. The first layer 132 overlaps the respective electric cables 100. The first layer 132 of FIGS. 7A and 7B, for example, extends longitudinally along and extends circumferentially about (e.g., circumscribes) the respective electric cables 100. The second layer 134 overlaps the first layer 132. The second layer 134 of FIGS. 7A and 7B, for example, extends longitudinally along and extends circumferentially about (e.g., circumscribes) the first layer 132. Referring to FIG. 7A, along at least a portion or the entirety of the conduit sidewall 128, the second layer 134 may be spaced radially out from the first layer 132 by an air gap 136. Referring to FIG. 7B, along at least a portion or the entirety of the conduit sidewall 128, the second layer 134 may alternatively engage (e.g., contact) and/or be attached (e.g., bonded) to the first layer 132. The first layer 132 may be disposed between the respective electric cables 100 and the second layer 134. This first layer 132 may be formed by, or may otherwise include, a layer of the non-ferrous metal. The second layer 134 may be disposed between the EMI source(s) (e.g., the electric machine system 110 of FIG. 2) outside of the cable conduit 112 and the first layer 132. This second layer 134 may be formed by, or may otherwise include, a layer of the dielectric material. The present disclosure, however, is not limited to such exemplary arrangements. For example, it is contemplated the positions of the first layer 132 and the second layer 134 may be reversed in other embodiments. In another example, referring to FIG. 7C, the conduit sidewall 128 may also include a third layer 138 overlapping the second layer 134, with the second layer 134 between the first layer 132 and the third layer 138. This third layer 138 may also be formed by, or may otherwise include, a layer of the non-ferrous metal. With this arrangement of FIG. 7C, the dielectric material may be sandwiched between and thermally protected by the non-ferrous metal. Note, while the second layer 134 of FIG. 7C is shown as engaging both the first layer 132 and the third layer 138, it is contemplated the second layer 134 may alternatively be spaced from the first layer 132 and/or the third layer 138 to provide an insulative air gap therebetween. Moreover, it is contemplated the first layer material may be the same as or different than the third layer material. By selecting a different third layer material than the first layer material, the cable conduit 112 may be further tuned for shielding electromagnetic interference and/or heat energy.

In some embodiments, referring to FIG. 3, the cable conduit 112 may be electrically grounded at the conduit first end 114 and/or the conduit second end 116. This facilitates electrical grounding of the cable conduit 112 itself. This may also facilitate electrical grounding of the electronic engine controller 104 and/or one or more of the electric devices 102 where, for example, the cable conduit 112 is electrically coupled to a ground terminal of the respective member(s) 102 and/or 104.

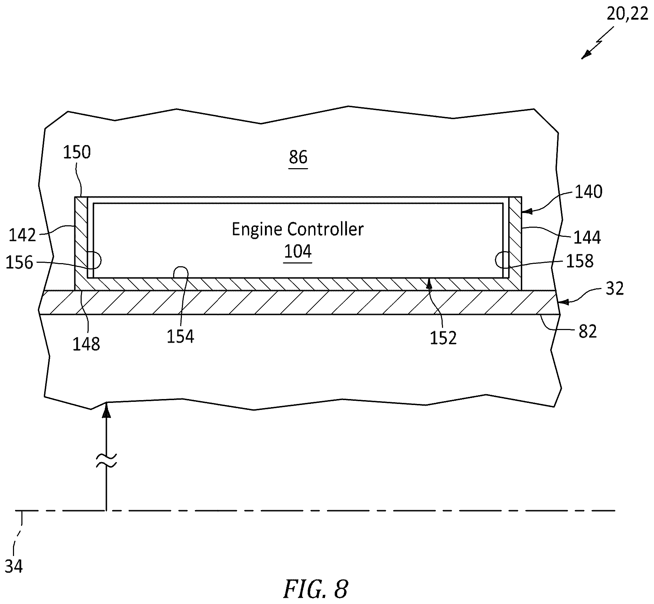

In some embodiments, referring to FIG. 4, the electronic engine controller 104 may be arranged with a shield structure 140. This shield structure 140 may be configured to block, deflect and/or otherwise shield the electromagnetic interference from the electronic engine controller 104. The shield structure 140 may also be configured to block, deflect and/or otherwise shield the electronic engine controller 104 from heat energy; e.g., heat radiated from the engine core 46 (see FIG. 1) and/or the electric machine system 110 (see FIG. 2). The shield structure 140 of FIG. 4 extends axially along the propulsion system axis 34 from a first end 142 of the shield structure 140 to a second end 144 of the shield structure 140. The shield structure 140 extends laterally between opposing lateral sides 146A and 146B of the shield structure 140. Referring to FIG. 8, the shield structure 140 extends radially from a radial inner side 148 of the shield structure 140 to a radial outer side 150 of the shield structure 140.

The shield structure 140 is configured with a receptacle 152 (e.g., a recess, a pocket, etc.) for the electronic engine controller 104. This controller receptacle 152 projects partially radially into the shield structure 140 from the structure outer side 150 to an inner bottom side 154 of the controller receptacle 152. Referring to FIG. 4, the controller receptacle 152 extends axially within the shield structure 140 between opposing axial sides 156 and 158 of the controller receptacle 152. The controller receptacle 152 extends laterally within the shield structure 140 between opposing lateral sides 160A and 160B of the controller receptacle 152. This controller receptacle 152 is sized and shaped to receive the electronic engine controller 104. The electronic engine controller 104 of FIGS. 4 and 8, for example, is seated in the controller receptacle 152 such that a radial inner side of the electronic engine controller 104 is (e.g., completely) axially and laterally covered by the shield structure 140. One or both axial sides and/or one or both lateral sides of the electronic engine controller 104 may also be partially or completely covered by the shield structure 140.

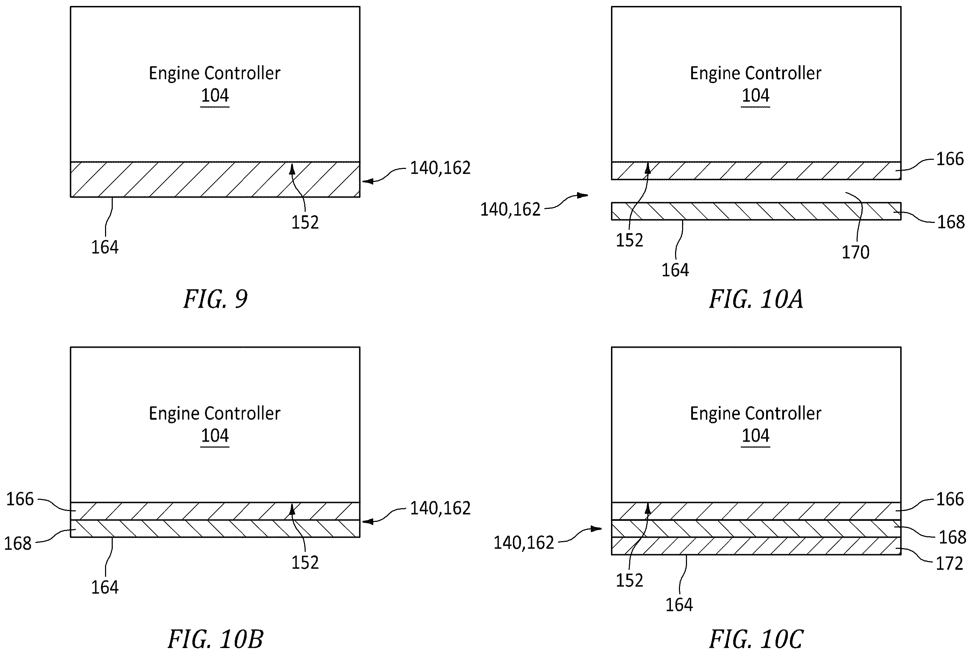

In some embodiments, referring to FIG. 9, at least a portion or an entirety of each wall 162 (e.g., a sidewall as shown in FIG. 4, an inner endwall as shown in FIG. 8) of the shield structure 140 may be configured with a single layer construction. The structure wall 162 of FIG. 9, for example, is formed by a layer of shield material. This shield material may be selected based on various factors including an electromagnetic interference (EMI) noise frequency range to be shielded. Here, this layer of shield material extends between and forms at least a portion or an entirety of the controller receptacle 152 and at least a portion or an entirety of an exterior 164 of the shield structure 140. The shield material may be any one of the shield materials described above. The present disclosure, however, is not limited to such exemplary shield materials.

In some embodiments, referring to FIGS. 10A and 10B, at least a portion or an entirety of each structure wall 162 may be configured with a multi-layer construction. The structure wall 162 of FIGS. 10A and 10B, for example, includes a first layer 166 and a second layer 168. The first layer 166 overlaps the electronic engine controller 104. The first layer 166 of FIGS. 10A and 10B, for example, extends axially, laterally and/or radially along the electronic engine controller 104. The second layer 168 overlaps the first layer 166. The second layer 168 of FIGS. 10A and 10B, for example, extends axially, laterally and/or radially along the first layer 166. Referring to FIG. 10A, along at least a portion or the entirety of the structure wall 162, the second layer 168 may be spaced out from the first layer 166 by an air gap 170. Referring to FIG. 10B, along at least a portion or the entirety of the structure wall 162, the second layer 168 may alternatively engage (e.g., contact) and/or be attached (e.g., bonded) to the first layer 166. The first layer 166 may be disposed between the electronic engine controller 104 and the second layer 168. This first layer 166 may be formed by, or may otherwise include, a layer of the non-ferrous metal. The second layer 168 may be disposed between the EMI source(s) (e.g., the electric machine system 110 of FIG. 2) outside of the electronic engine controller 104 and the first layer 166. This second layer 168 may be formed by, or may otherwise include, a layer of the dielectric material. The present disclosure, however, is not limited to such exemplary arrangements. For example, it is contemplated the positions of the first layer 166 and the second layer 168 may be reversed in other embodiments. In another example, referring to FIG. 10C, the structure wall 162 may also include a third layer 172 overlapping the second layer 168, with the second layer 168 between the first layer 166 and the third layer 172. This third layer 172 may also be formed by, or may otherwise include, a layer of the non-ferrous metal. With this arrangement of FIG. 10C, the dielectric material may be sandwiched between and thermally protected by the non-ferrous metal. Note, while the second layer 168 of FIG. 10C is shown as engaging both the first layer 166 and the third layer 172, it is contemplated the second layer 168 may alternatively be spaced from the first layer 166 and/or the third layer 172 to provide an insulative air gap therebetween. Moreover, it is contemplated the first layer material may be the same as or different than the third layer material. By selecting a different third layer material than the first layer material, the cable conduit 112 may be further tuned for shielding electromagnetic interference and/or heat energy.

FIG. 11 illustrates an exemplary arrangement for the electric machine system 110. This electric machine system 110 of FIG. 11 includes at least (or only) one electric machine 174 and at least (or only) one electric machine (EM) controller 176. Here, the electric machine 174 is electrically coupled to an electrical system 178 for the aircraft and its aircraft propulsion system 22 through the EM controller 176.

The electric machine 174 includes an electric machine rotor 180, an electric machine stator 182 and an electric machine housing 184. The machine rotor 180 is rotatable about a rotational axis 186 of the machine rotor 180, which rotational axis 186 may also be an axial centerline of the electric machine 174. The machine stator 182 of FIG. 11 is radially outboard of and circumscribes the machine rotor 180. With this arrangement, the electric machine 174 is configured as a radial flux electric machine. The electric machine 174 of the present disclosure, however, is not limited to such an exemplary rotor-stator configuration nor to radial flux arrangements. The machine rotor 180, for example, may alternatively be radially outboard of and circumscribe the machine stator 182. In another example, the machine rotor 180 may be axially next to the machine stator 182 configuring the electric machine 174 as an axial flux electric machine. Referring again to FIG. 11, the machine rotor 180 and the machine stator 182 are at least partially or completely housed within an interior of the machine housing 184.

The electric machine 174 of FIG. 11 is operatively coupled to a respective one of the engine rotating structures 68A, 68B (generally referred to as "68") through an engine-to-electric machine (EEM) drivetrain 188. The machine rotor 180 of FIG. 11, for example, is mechanically coupled to the respective engine rotating structure 68 through the EEM drivetrain 188; schematically shown. This EEM drivetrain 188 may be configured as or otherwise include a shaft, a tower shaft assembly, an accessory gearbox, another gearbox (e.g., an angle gearbox), and/or the like.

The electric machine 174 of FIG. 11 may be configurable as an electric motor and/or an electric generator; e.g., an electric motor-generator. For example, during a motor mode of operation, the electric machine 174 may operate as the electric motor to convert electricity received from the aircraft electrical system 178. The machine stator 182, for example, may generate an electromagnetic field with the machine rotor 180 using a current of electricity received from the aircraft electrical system 178 through the EM controller 176. This electromagnetic field may drive rotation of the machine rotor 180. The machine rotor 180, in turn, may provide mechanical power to and drive rotation of the respective engine rotating structure 68. This mechanical power may be provided to boost power or completely power the rotation of the respective engine rotating structure 68. By contrast, during a generator mode of operation, the electric machine 174 may operate as the electric generator to convert mechanical power received from the respective engine rotating structure 68 into electricity. Rotation of the machine rotor 180, for example, may be rotationally driven by rotation of the respective engine rotating structure 68. The rotation of the machine rotor 180 may generate an electromagnetic field with the machine stator 182, and the machine stator 182 may convert energy from the electromagnetic field into electricity. The electric machine 174 may then provide a current of electricity to the aircraft electrical system 178 through the EM controller 176 for storage and/or further use. The electric machine 174 of the present disclosure, however, is not limited to such exemplary operation. For example, the electric machine 174 may alternatively be configured as a dedicated electric generator; e.g., without the electric motor functionality. In another example, the electric machine 174 may be configured as a dedicated electric motor; e.g., without the electric generator functionality.

The EM controller 176 is electrically coupled to the electric machine 174 through one or more electric cables 190; e.g., high voltage electric cables, power feeder cables, etc. More particularly, controller circuitry 189 in the EM controller 176 is electrically coupled to the electric machine 174 and its machine stator 182 through the electric cables 190. Similarly, the EM controller 176 is electrically coupled to an electrical distribution bus 192 of the aircraft electrical system 178 through one or more electric cables 194; e.g., high voltage electric cables, power feeder cables, etc. More particularly, the controller circuitry 189 in the EM controller 176 is electrically coupled to the aircraft electrical system 178 and its electrical distribution bus 192 through the respective electric cables 194.

The EM controller 176 and its controller circuitry 189 are configured to control operation of the electric machine 174. For example, when operating as the electric motor, the EM controller 176 is configured to regulate a flow of electricity from the aircraft electrical system 178 to the electric machine 174. This electricity flow regulation may include: (a) turning-on the flow of electricity from the aircraft electrical system 178 to the electric machine 174 (e.g., electrically coupling the electric machine 174 to the aircraft electrical system 178); (b) turning-off the flow of electricity from the aircraft electrical system 178 to the electric machine 174 (e.g., electrically decoupling the electric machine 174 from the aircraft electrical system 178); (c) moderating the flow of electricity from the aircraft electrical system 178 to the electric machine 174. Here, the EM controller 176 operates as a motor controller. In another example, when operating as the electric generator, the EM controller 176 is configured to regulate a flow of electricity from the electric machine 174 to the aircraft electrical system 178. This electricity flow regulation may include: (a) turning-on the flow of electricity from the electric machine 174 to the aircraft electrical system 178 (e.g., electrically coupling the electric machine 174 to the aircraft electrical system 178); (b) turning-off the flow of electricity from the electric machine 174 to the aircraft electrical system 178 (e.g., electrically decoupling the electric machine 174 from the aircraft electrical system 178); (c) moderating the flow of electricity from the electric machine 174 to the aircraft electrical system 178. Here, the EM controller 176 operates as a generator controller.

The aircraft electrical system 178 includes the electrical distribution bus 192. This aircraft electrical system 178 may also include a power source 196 and/or a power storage 198. The electrical distribution bus 192 is electrically coupled to the electric machine 174 through the EM controller 176. The electrical distribution bus 192 is also electrically coupled to the power source 196 and the power storage 198, respectively via electric cables 200 and 202; e.g., high voltage electric cables, power feeder cables, etc. With this arrangement, the electrical distribution bus 192 provides an intermediate connection between the various electrical aircraft propulsion system members 174 (via 176), 196 and 198. The power source 196 may be an electric generator powered by the turbine engine 24 (see FIG. 1) or an electric generator powered by another aircraft powerplant; e.g., an engine of a companion aircraft propulsion system, an engine of an auxiliary power unit (APU), a fuel cell system, etc. The power storage 198 is configured to receive electricity from the electrical distribution bus 192 for storage. The power storage 198 is also configured to provide the stored electricity to the electrical distribution bus 192. The power storage 198, for example, may be configured as or otherwise include one or more electricity storage devices; e.g., batteries, super capacitors, etc.

While various embodiments of the present disclosure have been described, it will be apparent to those of ordinary skill in the art that many more embodiments and implementations are possible within the scope of the disclosure. For example, the present disclosure as described herein includes several aspects and embodiments that include particular features. Although these features may be described individually, it is within the scope of the present disclosure that some or all of these features may be combined with any one of the aspects and remain within the scope of the disclosure. Accordingly, the present disclosure is not to be restricted except in light of the attached claims and their equivalents.

## Claims

1. An assembly for an aircraft powerplant, comprising:
an aircraft engine;
a control system including an electronic engine controller, a first electric device and a first electric cable electrically coupling the first electric device to the electronic engine controller, the electronic engine controller configured to control operation of the aircraft engine using the first electric device; and
a conduit extending longitudinally from a first end of the conduit to a second end of the conduit, the first electric cable extending longitudinally in a bore of the conduit between the electronic engine controller and the first electric device, and the conduit configured to shield the first electric cable from electromagnetic interference generated outside of the conduit.

2. The assembly of claim 1, wherein:
the first electric device comprises a sensor; and
the sensor is configured to communicate sensor data to the electronic engine controller through the first electric cable.

3. The assembly of claim 1 or 2, wherein:
the first electric device comprises an actuatable device; and
the electronic engine controller is configured to communicate a command to the actuatable device through the first electric cable.

4. The assembly of claim 1, 2 or 3, wherein:
the first electric device comprises a second electronic controller; and
the electronic engine controller and the second electronic controller are configured to communicate through the first electric cable.

5. The assembly of any preceding claim, further comprising an electric machine system operable to generate the electromagnetic interference.

6. The assembly of claim 5, wherein the electric machine system comprises:
an electric machine operatively coupled to the aircraft engine; and
an electric machine controller configured to control operation of the electric machine.

7. The assembly of any preceding claim, wherein:
the first end of the conduit is disposed at the electronic engine controller; and
the second end of the conduit is disposed at the first electric device.

8. The assembly of any preceding claim, wherein a sidewall of the conduit comprises at least one of:
non-ferrous metal; or
dielectric material.

9. The assembly of any preceding claim, wherein:
a sidewall of the conduit comprises a first layer and a second layer extending along the first layer;
the first layer comprises non-ferrous metal; and
the second layer comprises dielectric material.

10. The assembly of claim 9, wherein:
the second layer extends along and circumscribes the first electric cable; and
the first layer extends along and circumscribes the second layer, or wherein:
the first layer extends along and circumscribes the first electric cable; and
the second layer extends along and circumscribes the first layer.

11. The assembly of claim 9 or 10, wherein:
the sidewall of the conduit further comprises a third layer extending along the first layer and the second layer; and
the third layer comprises the non-ferrous metal, or wherein:
the sidewall of the conduit further comprises a third layer extending along the first layer and the second layer; and
the third layer comprises a second metal that is different than the non-ferrous metal of the first layer.

12. The assembly of any preceding claim, wherein the control system further includes a second electric device and a second electric cable electrically coupling the second electric device to the electronic engine controller, and the second electric cable extends longitudinally in the bore of the conduit between the electronic engine controller and the second electric device.

13. The assembly of any preceding claim, further comprising:
a housing structure for the aircraft engine, the housing structure including an inner case and an outer case with a bypass flowpath disposed radially between the inner case and the outer case;
a first portion of the conduit extends along the inner case; and
a second portion of the conduit extends along the outer case.

14. The assembly of claim 13, wherein:
the housing structure further includes a bifurcation structure extending radially across the bypass flowpath; and
a third portion of the conduit extends through the bifurcation structure.

15. The assembly of any preceding claim, further comprising a shield structure for the electronic engine controller, the shield structure configured to shield the electronic engine controller from the electromagnetic interference generated outside of the electronic engine controller, optionally wherein:
the shield structure comprises an open receptacle;
the open receptacle projects into the shield structure; and
the electronic engine controller is seated in the open receptacle.
